# FASCICULE DE BREVET EUROPEEN

(11) **EP 3 566 308 B1**
(45) Date de publication et mention de la délivrance du brevet: **08.11.2023**
(21) Numéro de dépôt: 18701511.0
(22) Date de dépôt: 02.01.2018
(51) Int. Cl.: H03K 19/0185, B06B 1/02

(54) **CIRCUIT DE COMMANDE DE TRANSDUCTEURS ULTRASONORES**
STEUERGERÄT FÜR EINEN ULTRASCHALLWANDLER
CONTROL DEVICE FOR AN ULTRASONIC SOUND CONVERTER

(30) Priorité: 04.01.2017 FR 1750071
(43) Date de publication de la demande: 13.11.2019
(73) Titulaire: Moduleus, 37100 Tours (FR)
(72) Inventeur: CHATAIN, Pascal, 37170 Chambray-Les-Tours (FR); ROY, Mathieu, 37300 Joue-Les-Tours (FR); FLESCH, Etienne, 78570 Andresy (FR); JEANNE, Edgard, 37000 Tours (FR)
(74) Mandataire: Cabinet Beaumont
(86) Numéro de dépôt international: PCT/FR2018/050003
(87) Numéro de publication internationale: WO 2018/127655

(56) Documents cités:
- WO-A1-2009/073743
- US-A1- 2005 154 300
- US-A1- 2011 201 936
- US-B1- 6 645 145

## Description

La présente demande de brevet revendique la priorité de la demande de brevet français FR17/50071.

### Domaine

La présente demande concerne le domaine de l'imagerie ultrasonore, et vise plus particulièrement un circuit électronique de commande de transducteurs ultrasonores d'un système d'imagerie ultrasonore.

### Exposé de l'art antérieur

Un système d'imagerie ultrasonore comprend classiquement une pluralité de transducteurs ultrasonores, par exemple disposés en barrette ou en matrice comme décrit par exemple dans le document US 6 645 145 B1. En fonctionnement, l'ensemble des transducteurs est disposé en vis-à-vis d'un corps dont on souhaite acquérir une image. Le système comprend en outre un circuit électronique de commande adapté à appliquer des signaux électriques d'excitation aux transducteurs, de façon à provoquer l'émission d'ondes ultrasonores par les transducteurs. Les ondes ultrasonores émises par les transducteurs sont réfléchies par le corps à analyser (par sa structure interne et/ou superficielle), puis reviennent vers les transducteurs qui les convertissent à nouveau en signaux électriques. Ces signaux électriques de réponse sont lus par le circuit électronique de commande, et peuvent être mémorisés et analysés pour en déduire des informations sur le corps étudié.

Les systèmes d'imagerie ultrasonore traditionnels sont des systèmes relativement complexes et coûteux, utilisés par exemple dans le domaine médical (échographie) ou pour des applications industrielles (contrôle non destructif de matériaux). Plus récemment, des applications destinées au grand public ont été proposées, par exemples des applications de biométrie, dans lesquelles un capteur à transducteurs ultrasonores est utilisé pour acquérir une signature biométrique d'un utilisateur, par exemple une empreinte digitale. Par rapport aux capteurs biométriques de type optique, un avantage est une amélioration de la fiabilité de l'identification liée notamment à l'intégration d'information quant à la structure interne du membre (doigt, paume, etc.) utilisé pour l'identification.

Il serait souhaitable de pouvoir améliorer au moins en partie certains aspects des systèmes d'imagerie ultrasonore existants. En particulier, il serait souhaitable de pouvoir réduire le coût de tels systèmes, et notamment le coût lié au circuit électronique de commande des transducteurs. Ceci est tout particulièrement important pour les applications destinées au grand public, dans lesquelles le coût du circuit électronique de commande des transducteurs peut représenter une partie significative du coût total du système.

### Résumé

L'invention est défini par les caractéristiques de la revendication 1 et concerne un circuit de commande de transducteurs ultrasonores, caractérisé en ce qu'il est configurable en fonction du type de transducteurs à commander.

Selon l'invention, le circuit de commande comporte une première borne destinée à être reliée à une première électrode de chacun des transducteurs, et un commutateur de polarisation configurable pour relier la première borne à l'un ou l'autre de premier et deuxième noeuds de polarisation en fonction du type de transducteurs à commander.

Selon un mode de réalisation, le premier noeud de polarisation est un noeud de sortie d'un circuit de fourniture d'une tension de polarisation continue, et le deuxième noeud de polarisation est un noeud d'application d'un potentiel de référence du circuit.

Selon un mode de réalisation, le circuit de fourniture d'une tension de polarisation continue comprend un convertisseur de tension continu-continu configurable pour modifier le niveau de la tension de polarisation qu'il délivre.

Selon un mode de réalisation, le circuit de commande comprend une pluralité de deuxièmes bornes destinées à être reliées respectivement à des deuxièmes électrodes des transducteurs à commander.

Selon un mode de réalisation, le circuit de commande comprend une pluralité de générateurs d'impulsions de tension, chacune des deuxièmes bornes étant reliée à l'un des générateurs d'impulsions de tension.

Selon un mode de réalisation, le niveau de tension des impulsions de tension délivrées par les générateurs d'impulsions est configurable.

Selon l'invention, le circuit de commande comprend en outre un circuit de réception comportant un noeud d'entrée, un amplificateur de réception dont l'entrée est reliée au noeud d'entrée, un convertisseur analogique-numérique dont l'entrée est reliée à la sortie de l'amplificateur de réception, et une sortie reliée à la sortie du convertisseur analogique-numérique.

Selon un mode de réalisation, le circuit de commande comprend une pluralité d'interrupteurs reliant respectivement les deuxièmes bornes au noeud d'entrée du circuit de réception.

Selon un mode de réalisation, le circuit de réception comprend un circuit d'adaptation d'impédance configurable en fonction du type de transducteurs à commander.

Selon un mode de réalisation, le circuit de réception comprend en outre, entre l'amplificateur de réception et le convertisseur analogique-numérique, au moins l'un des éléments suivants :
un circuit analogique d'ajustement de gain ; et
un filtre analogique antirepliement.

Selon l'invention, le circuit de réception comprend un réseau de capacités commutées disposé en amont du convertisseur analogique-numérique, permettant de mémoriser des échantillons analogiques représentatifs du signal de sortie de l'amplificateur de réception, préalablement à leur numérisation par le convertisseur analogique-numérique.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est un schéma électrique simplifié illustrant un exemple d'un mode de réalisation d'un circuit électronique de commande de transducteurs ultrasonores ;
la figure 2 est un schéma électrique illustrant plus en détail un exemple de réalisation d'un générateur d'impulsions du circuit de commande de la figure 1 ;
la figure 3 est un schéma électrique illustrant plus en détail un autre exemple de réalisation d'un générateur d'impulsions du circuit de commande de la figure 1 ;
les figures 4A, 4B et 4C sont des schémas électriques illustrant plus en détail trois variantes de réalisation d'un amplificateur de réception du circuit de commande de la figure 1 ; et
la figure 5 est un schéma électrique illustrant une variante de réalisation d'un circuit de réception du circuit de commande de la figure 1.

### Description détaillée

De mêmes éléments ont été désignés par de mêmes références aux différentes figures. Par souci de clarté, seuls les éléments qui sont utiles à la compréhension des modes de réalisation décrits ont été représentés et sont détaillés. En particulier, les diverses applications que peuvent avoir le circuit de commande décrit n'ont pas été détaillées, les modes de réalisation décrits étant compatibles avec les applications usuelles des systèmes d'imagerie ultrasonore. De plus, les propriétés (fréquences, formes, amplitudes, etc.) des signaux électriques d'excitation appliqués par le circuit de commande aux transducteurs ultrasonores n'ont pas été détaillées, les modes de réalisation décrits étant compatibles avec les signaux d'excitation usuellement utilisés dans les systèmes d'imagerie ultrasonore, qui peuvent être choisis en fonction de l'application considérée et en particulier de la nature du corps à analyser et du type d'information que l'on cherche à acquérir.

Dans la présente description, on utilise le terme "connecté" pour désigner une liaison électrique directe, sans composant électronique intermédiaire, par exemple au moyen d'une ou plusieurs pistes conductrices ou fils conducteurs, et le terme "couplé" ou le terme "relié", pour désigner une liaison électrique qui peut être directe (signifiant alors "connecté") ou indirecte (c'est-à-dire via un ou plusieurs composants intermédiaires).

Dans les systèmes d'imagerie ultrasonore existants, le circuit électronique de commande des transducteurs est un circuit spécifiquement conçu pour l'application considérée, et notamment en fonction du type de transducteurs utilisé. En effet, il existe différentes technologies de transducteurs ultrasonores, par exemple des transducteurs piézoélectriques, des transducteurs à cristal, des transducteurs CMUT (transducteurs capacitifs à membrane), etc.. Selon la technologie choisie, et/ou, pour une technologie donnée, selon les dimensions des transducteurs, les contraintes sur le circuit de commande peuvent être différentes, notamment en ce qui concerne la puissance des signaux d'excitation appliqués aux transducteurs, le niveau de la tension de polarisation appliquée aux transducteurs, et/ou l'adaptation d'impédance entre les transducteurs et les circuits de lecture des signaux électriques de réponse produits par les transducteurs.

La prévision d'un circuit de commande spécifique pour chaque application d'imagerie ultrasonore se traduit par des coûts de développement importants, et donc par un prix de revient relativement élevé du circuit de commande.

Selon un aspect d'un mode de réalisation, on prévoit un circuit de commande de transducteurs ultrasonores configurable ou paramétrable en fonction du type de transducteurs à commander. Un tel circuit présente l'avantage de pouvoir être utilisé pour différentes applications, et en particulier pour commander des transducteurs de différentes technologies et/ou présentant des dimensions différentes. Ceci permet de ne pas avoir à développer un circuit de commande spécifique pour chaque application d'imagerie ultrasonore, et ainsi de réaliser des économies d'échelle.

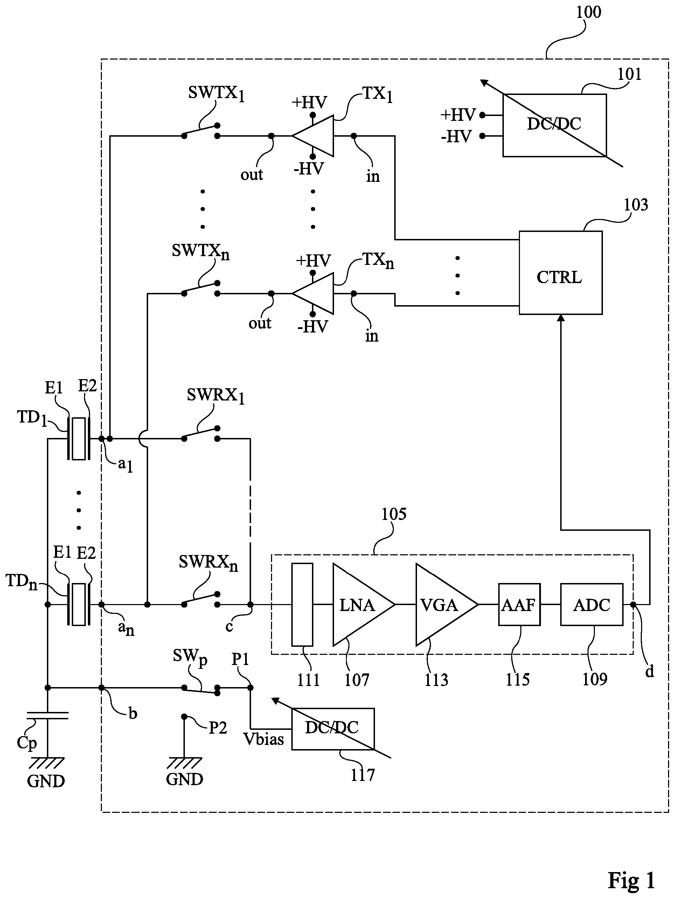

La figure 1 est un schéma électrique simplifié illustrant un exemple d'un mode de réalisation d'un circuit électronique de commande 100 de transducteurs ultrasonores. Sur la figure 1, outre le circuit de commande 100, ont été représentés n transducteurs ultrasonores TD₁, ..., TDₙ à commander, où n est un entier supérieur à 1, par exemple compris entre 10 et 5000, ainsi qu'un condensateur de polarisation Cp. Les transducteurs TD₁, ..., TDₙ du système de la figure 1 sont par exemple identiques aux dispersions de fabrication près. A titre d'exemple, les transducteurs TD₁, ..., TDₙ sont des transducteurs piézoélectriques, des transducteurs à cristal, ou des transducteurs CMUT. Chaque transducteur ultrasonore TDᵢ, avec i entier allant de 1 à n, comprend deux électrodes E1 et E2. Lorsqu'une tension d'excitation appropriée est appliquée entre les électrodes E1 et E2, le transducteur émet une onde acoustique ultrasonore. Lorsque le transducteur reçoit une onde acoustique ultrasonore dans une certaine gamme de fréquence, il fournit entre ses électrodes E1 et E2 une tension représentative de l'onde reçue.

Le circuit 100 comprend n bornes a₁, ..., aₙ, destinées à être reliées respectivement aux électrodes E2 des transducteurs TD₁, ..., TDₙ. Le circuit 100 comprend en outre une borne b unique destinée à être reliée aux électrodes E1 des transducteurs TD₁, ... TDₙ. Dans l'exemple représenté, les électrodes E2 des transducteurs TD₁, ..., TDₙ sont connectées respectivement aux bornes a₁, ..., aₙ du circuit de commande 100, et les électrodes E1 des transducteurs TD₁, ..., TDₙ sont connectées à la borne b du circuit de commande 100.

Le condensateur de polarisation Cp du système de la figure 1 relie la borne b du circuit 100 à un noeud GND d'application d'un potentiel de référence du système, par exemple la masse. Dans l'exemple représenté, le condensateur Cp est externe au circuit 100. A titre de variante, le condensateur Cp peut être inclus dans le circuit 100.

Le circuit de commande 100 de la figure 1 comprend, pour chaque transducteur ultrasonore TDᵢ, un générateur d'impulsions TXᵢ et un interrupteur commandable SWTXᵢ reliant un noeud de sortie out du générateur d'impulsions TXᵢ à la borne aᵢ du circuit couplée à l'électrode E2 du transducteur TDᵢ. Les générateurs d'impulsions TX₁, ... TXₙ associés aux différents transducteurs sont par exemple identiques aux dispersions de fabrication près. De plus, les interrupteurs SWTX₁, ..., SWTXₙ peuvent être identiques aux dispersions de fabrication près. Chaque générateur d'impulsions TXᵢ comprend un noeud d'entrée in adapté à recevoir un signal logique de commande. Lorsque le signal logique appliqué sur le noeud d'entrée in du générateur TXᵢ est à un premier état, le générateur TXᵢ fourni sur son noeud de sortie out une tension de niveau haut +HV, et, lorsque le signal logique appliqué sur le noeud in du générateur TXᵢ est à un deuxième état, le générateur TXᵢ fourni sur son noeud de sortie out une tension de niveau bas -HV. A titre d'exemple, les tensions +HV et -HV sont respectivement positive et négative par rapport à la tension de référence du circuit appliquée sur le noeud GND. A titre de variante, la tension -HV est égale à la tension de référence du circuit, et la tension +HV est positive par rapport à la tension de référence du circuit. Le signal de sortie du générateur d'impulsions TXᵢ correspond à un signal d'excitation du transducteur TDᵢ, qui peut être appliqué sur l'électrode E2 du transducteur TDᵢ par l'intermédiaire de l'interrupteur SWTXᵢ. Le niveau de tension de ce signal d'excitation est relativement élevé, par exemple de l'ordre de 10 à 50 volts crête à crête (c'est-à-dire entre le niveau bas -HV et le niveau haut +HV). Dans l'exemple de la figure 1, le circuit 100 comprend un convertisseur de tension continu-continu (DC/DC) 101, adapté à générer, à partir d'une tension d'alimentation (non représentée) du circuit 100, par exemple comprise entre 1 et 5 volts, les tensions d'alimentation +HV, et, le cas échéant, -HV des générateurs d'impulsions TXᵢ. De préférence, le convertisseur continu-continu 101 est configurable pour modifier le niveau des tensions de sortie +HV, et, le cas échéant, -HV délivrés, ce qui permet de rendre le circuit 100 compatible avec différents types de transducteurs ultrasonores adaptés à recevoir différents niveaux de tension d'excitation. Dans l'exemple représenté, le convertisseur continu-continu 101 est un convertisseur unique partagé par les différents générateurs d'impulsions TXᵢ. A titre de variante, chaque générateur d'impulsion TXᵢ peut être couplé à son propre convertisseur continu-continu.

Le circuit de commande 100 de la figure 1 comprend de plus un circuit logique de contrôle 103 (CTRL) relié aux noeuds d'entrée in des différents générateurs d'impulsions TXᵢ. Le circuit de contrôle 103 est adapté à appliquer des séquences logiques de commande aux différents générateurs d'impulsions. Le circuit 103 peut commander individuellement les différents générateurs d'impulsions TX₁, ..., TXₙ, de façon simultanée ou séquentiellement. Le circuit de contrôle 103 comprend par exemple un ou plusieurs circuits numériques de traitement ou de conditionnement (non détaillés), par exemple de type microprocesseur ou circuit logique programmable (par exemple FPGA), et un ou plusieurs circuits mémoire (non détaillés). Le circuit de contrôle 103 est par exemple adapté à mémoriser une pluralité de scénarii d'excitation des transducteurs prédéterminés, correspondant par exemple à des fréquences d'excitation distinctes, et pouvant être sélectionnés par l'utilisateur en fonction de l'application envisagée, et en particulier en fonction du type de transducteurs utilisé, et/ou en fonction du type de corps à analyser, et/ou en fonction du type d'image ou d'information recherché. Dans le cas où le convertisseur continu-continu 101 est configurable, ce dernier peut par exemple être configuré par l'intermédiaire du circuit de contrôle 103, via une liaison de configuration non représentée.

Le circuit électronique de commande 100 de la figure 1 comprend en outre un circuit de réception 105 adapté à amplifier et numériser les signaux électriques de réponse générés par les transducteurs ultrasonores. Le circuit 100 de la figure 1 comprend de plus n interrupteurs commandables SWRX₁, ..., SWRXₙ, reliant respectivement les bornes a₁, ..., aₙ à un noeud c d'entrée du circuit de réception 105. Le circuit de réception 105 comprend un amplificateur de réception 107, de préférence à faible bruit (LNA), dont l'entrée est reliée au noeud c, et un convertisseur analogique numérique 109 (ADC), dont l'entrée est reliée à la sortie de l'amplificateur 107 et dont la sortie est reliée à une sortie d (sur plusieurs bits) du circuit de réception 105. La sortie d du circuit de réception 105 est reliée au circuit de contrôle 103. A titre d'exemple, le convertisseur 109 est adapté à fournir, sur la sortie d, des échantillons numériques quantifiés sur 8 à 24 bits, par exemple sur 14 bits, représentatifs de l'amplitude du signal d'entrée du convertisseur, à une fréquence de numérisation comprise entre 50 et 250 MHz, par exemple à une fréquence de 120 MHz.

Dans l'exemple de la figure 1, le circuit de réception 105 comprend en outre, entre le noeud c et l'entrée de l'amplificateur 107, un circuit d'adaptation d'impédance 111 permettant, en cas de besoin, d'adapter l'impédance d'entrée de l'amplificateur 107 à l'impédance des transducteurs ultrasonores. De préférence, le circuit d'adaptation d'impédance 111 est configurable, ce qui permet de rendre le circuit 100 compatible avec différents types de transducteurs ultrasonores présentant des impédances différentes. A titre d'exemple, le circuit d'adaptation d'impédance 111 comprend un réseau configurable de résistances et/ou de capacités. Dans le cas où le circuit d'adaptation d'impédance 111 est configurable, ce dernier peut par exemple être configuré par l'intermédiaire du circuit de contrôle 103, via une liaison de configuration non représentée.

Dans l'exemple de la figure 1, le circuit de réception 105 comprend en outre, entre la sortie de l'amplificateur 107 et l'entrée du convertisseur analogique-numérique 109, un circuit 113 d'ajustement de gain (VGA). Le circuit 113 est par exemple commandable numériquement par le circuit de contrôle 103. Le circuit 113 permet d'appliquer un gain variable au signal de sortie de l'amplificateur 107 au cours d'une phase de lecture du signal retour reçu par un transducteur ultrasonore. A titre d'exemple, lors d'une phase de lecture du signal retour reçu par un transducteur ultrasonore, le circuit de contrôle 103 commande le circuit 113 pour augmenter progressivement le gain appliqué au signal de sortie de l'amplificateur 107. En effet, lors d'une phase de réception d'un signal ultrasonore réfléchi par le corps à analyser, l'amplitude du signal réfléchi diminue avec le temps, dans la mesure où, plus le temps passe, plus la distance parcourue par le signal réfléchi est importante, et plus le signal réfléchi est atténué. L'augmentation progressive du gain appliqué par le circuit d'ajustement 113 permet de maximiser l'amplitude du signal appliqué en entrée du convertisseur analogique-numérique 109, et donc de minimiser le bruit de quantification introduit par le convertisseur 109.

Dans l'exemple de la figure 1, le circuit de réception 105 comprend en outre un filtre analogique antirepliement 115 (AAF), par exemple un filtre passe bas, disposé entre la sortie de l'amplificateur 107 et l'entrée du convertisseur analogique numérique 109. Dans l'exemple représenté, le filtre 115 est disposé entre la sortie du circuit d'ajustement de gain 113 et l'entrée du convertisseur 109.

Le circuit de commande 100 de la figure 1 comprend de plus un commutateur de polarisation SWp, configurable pour relier le noeud b soit à un premier noeud de polarisation P1, soit à un deuxième noeud de polarisation P2, en fonction du type des transducteurs TDᵢ connectés au circuit de commande 100. Le commutateur SWp peut par exemple être commandé par l'intermédiaire du circuit de contrôle 103.

Dans l'exemple de la figure 1, le noeud P1 est un noeud de sortie d'un circuit 117 de fourniture d'une tension de polarisation continue V_{bias}, par exemple une tension positive par rapport à la tension de référence ou masse du circuit. A titre d'exemple, la tension de polarisation V_{bias} est comprise entre 5 et 200 V, par exemple de l'ordre de 30 V. Une telle tension de polarisation est tout particulièrement adaptée à des transducteurs de type CMUT. Ainsi, lorsque le circuit 100 est utilisé pour commander des transducteurs de type CMUT, le commutateur SWp peut être configuré pour connecter le noeud b au noeud P1. Le circuit 117 est par exemple un convertisseur de tension continu-continu (DC/DC), adapté à générer la tension de polarisation V_{bias} à partir d'une tension d'alimentation (non représentée) du circuit 100, par exemple comprise entre 1 et 5 volts. De préférence, le circuit 117 est configurable pour modifier le niveau de la tension de polarisation V_{bias} délivrée, ce qui permet de rendre le circuit 100 compatible avec différents types de transducteurs ultrasonores adaptés à recevoir des niveaux de tension de polarisation différents, ou, pour un type de transducteur donné, de modifier le coefficient de conversion mécano-électrique du transducteur. Dans le cas où le circuit 117 est configurable, ce dernier peut par exemple être configuré par l'intermédiaire du circuit de contrôle 103.

Dans l'exemple de la figure 1, le noeud P2 est connecté au noeud de référence ou masse GND du circuit. Le commutateur SWp peut être configuré pour connecter le noeud b au noeud P2 lorsque le circuit 100 est utilisé pour commander des transducteurs ultrasonores de type piézoélectrique ou à cristal, dans la mesure où ces transducteurs ne nécessitent pas d'être polarisés.

A titre d'exemple, les différents composants du circuit de commande 100 de la figure 1 peuvent être intégrés dans une ou plusieurs puces de circuits intégrés, non représentées. Par exemple, les générateurs d'impulsions TXᵢ, les interrupteurs SWTXᵢ et SWRXᵢ, le convertisseur continu-continu 101, le circuit de polarisation 117, et le commutateur de polarisation SWp sont intégrés dans une même première puce de circuit intégré, et le circuit de réception 105 et le circuit de contrôle 103 sont intégrés dans une même deuxième puce de circuit intégré. Les modes de réalisation décrits ne se limitent toutefois pas à ce cas particulier.

Dans l'exemple de la figure 1, le circuit de commande 100 comprend un unique circuit de réception 105 partagé par les différents transducteurs TD₁, ..., TDₙ. Dans ce cas, plusieurs tirs d'ultrasons successifs peuvent être réalisés pour acquérir une image du corps à analyser. Un exemple de fonctionnement du système est le suivant. Lors d'une première phase d'émission d'ultrasons, les interrupteurs SWTX₁, ..., SWTXₙ sont tous fermés (mis à l'état passant), et le circuit de contrôle 103 commande simultanément les générateurs d'impulsions TX₁, ... TXₙ pour appliquer des signaux d'excitation aux différents transducteurs. Pour cela, le circuit de contrôle 103 applique sur l'entrée de chaque générateur d'impulsions TXᵢ une séquence logique (ou train de bits) prédéterminée, représentative du signal d'excitation à appliquer au transducteur TDᵢ. Ce signal logique est converti par le générateur TXᵢ en un train d'impulsions de niveau +HV/-HV, appliqué à l'électrode E2 du transducteur TDᵢ par l'intermédiaire de l'interrupteur SWTXᵢ. A titre d'exemple, la fréquence propre, c'est-à-dire la fréquence de résonance principale des transducteurs ultrasonores TDᵢ, est comprise entre 10 et 50 MHz, par exemple de l'ordre de 30 MHz. La cadence de la séquence logique appliquée à l'entrée du générateur d'impulsions TXᵢ, et donc du train d'impulsions appliqué au transducteur TDᵢ, est de préférence supérieure à quatre fois la fréquence propre du transducteur TDi, de façon à pouvoir assurer une bonne couverture spectrale en émission, par exemple 120 MHz pour un transducteur à 30 MHz. A la fin de la phase d'émission, les interrupteurs SWTX₁, ..., SWTXₙ sont ouverts (bloqués), et un premier interrupteur de réception SWRXᵢ est fermé, les autres interrupteurs de réception étant maintenus ouverts. Le signal de réponse généré par le transducteur TDᵢ est alors lu et numérisé via le circuit de réception 105 lors d'une première phase de réception. Ce signal peut être mémorisé par le circuit de contrôle 103. Les phases d'émission et de réception sont ensuite réitérées en balayant, en réception, les différents transducteurs TD₁, ..., TDₙ, c'est-à-dire en modifiant à chaque itération l'adresse de l'interrupteur de réception SWRXᵢ commandé à l'état fermé pendant la phase de réception. La commande des interrupteurs d'émission SWTXᵢ et de réception SWRXᵢ est par exemple réalisée par l'intermédiaire du circuit de contrôle 103.

A titre de variante (non représentée), le circuit de commande 100 comporte n circuits de réception 105₁, ..., 105ₙ identiques ou similaires au circuit 105 décrit ci-dessus, reliés respectivement aux n bornes a₁, ..., aₙ. Dans ce cas, les interrupteurs de réception SWRX₁, ... SWRXₙ peuvent être omis, chaque voie de réception 105ᵢ ayant son noeud d'entrée c connecté à la borne aᵢ correspondante. Dans cette variante, les signaux retour reçus par les n transducteurs peuvent être lus simultanément. Ainsi, une image de l'objet à analyser peut être obtenue après un unique cycle d'émission/réception d'ultrasons par les transducteurs.

Dans une autre variante, le circuit de commande 100 comporte un nombre r de circuits de réception intermédiaire entre 1 et n, ce qui permet d'acquérir une image de l'objet après n/r cycles d'émission/réception d'ultrasons.

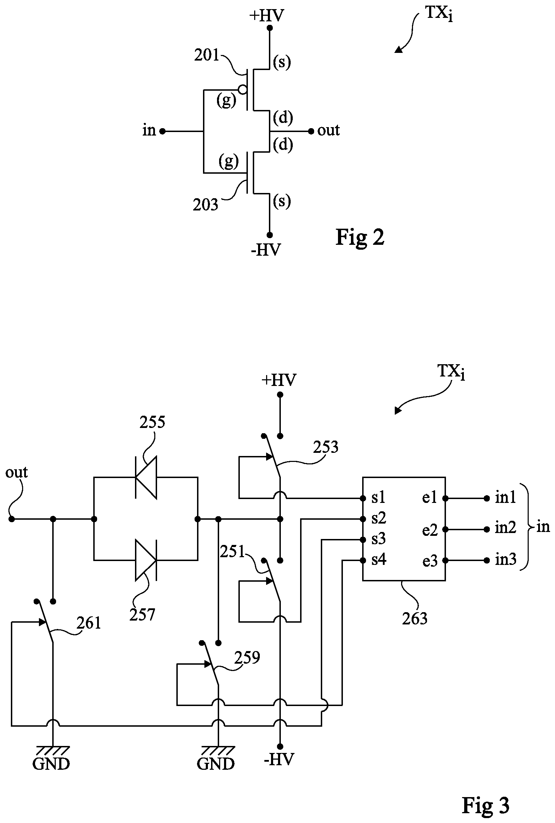

La figure 2 est un schéma électrique illustrant plus en détail un exemple de réalisation d'un générateur d'impulsions TXᵢ du circuit de commande 100 de la figure 1. Dans cet exemple, le générateur d'impulsions TXᵢ est un montage de type push-pull à base de transistors MOS. Plus particulièrement, le générateur d'impulsions TXᵢ de la figure 2 comprend un transistor MOS à canal P 201 et un transistor MOS à canal N 203. Le transistor 201 a sa source (s) reliée à un noeud d'application de la tension d'alimentation haute +HV du générateur et son drain (d) relié au drain (d) du transistor 203. Le transistor 203 a sa source (s) reliée à un noeud d'application de la tension d'alimentation basse -HV du générateur. La grille (g) du transistor 201 est en outre reliée à la grille (g) du transistor 203. Le noeud d'entrée in du générateur d'impulsions TXᵢ est relié au noeud commun aux grilles des transistors 201 et 203, et le noeud de sortie out du générateur d'impulsions TXᵢ est relié au noeud commun aux sources des transistors 201 et 203.

A titre de variante, un montage similaire peut être réalisé en remplaçant le transistor 201 par un transistor bipolaire de type NPN et le transistor 203 par un transistor bipolaire de type PNP.

La figure 3 est un schéma électrique illustrant plus en détail un autre exemple de réalisation d'un générateur d'impulsions TXᵢ du circuit de commande 100 de la figure 1.

Dans cet exemple, le générateur d'impulsions TXᵢ comprend deux interrupteurs commandés 251 et 253, par exemple des transistors MOS ou des transistors bipolaires, connectés en série entre un noeud d'application de la tension d'alimentation basse -HV du générateur, et un noeud d'application de la tension d'alimentation haute +HV du générateur. Plus particulièrement, dans l'exemple représenté, l'interrupteur 251 a un premier noeud de conduction connecté au noeud -HV et un deuxième noeud de conduction, et l'interrupteur 253 a un premier noeud de conduction connecté au deuxième noeud de conduction de l'interrupteur 251 et un deuxième noeud de conduction connecté au noeud +HV. Le générateur d'impulsions TXᵢ comprend en outre deux diodes 255 et 257 reliées en antiparallèle entre le point milieu entre les interrupteurs 251 et 253 et le noeud de sortie out du générateur. Plus particulièrement, dans l'exemple représenté, la diode 255 a son anode connectée au noeud de conduction commun entre les interrupteurs 251 et 253 et sa cathode connectée au noeud out, et la diode 257 a son anode connectée au noeud out et sa cathode connectée au noeud de conduction commun entre les interrupteurs 251 et 253. Le générateur d'impulsions TXᵢ de la figure 3 comprend de plus un interrupteur commandé 259, par exemple un transistor MOS ou un transistor bipolaire, reliant, par ses noeuds de conduction, le point milieu entre les interrupteurs 251 et 253 au noeud de référence GND, et un interrupteur commandé 261, par exemple un transistor MOS ou un transistor bipolaire, reliant, par ses noeuds de conduction, le noeud out au noeud GND. Le générateur d'impulsions TXᵢ comprend en outre un circuit logique 263 à trois entrées binaires e1, e2, e3 et trois sorties binaires s1, s2, s3, s4. Les sorties s1, s2, s3 et s4 du circuit 263 sont reliées respectivement aux noeuds de commande des interrupteurs 253, 255, 261 et 259 pour commander ces transistors. Dans cet exemple, le signal logique in de commande du générateur d'impulsion TXᵢ, fourni par le circuit de contrôle 103 de la figure 1, est un signal sur trois bits in1, in2, in3, les bits in1, in2, in3 étant respectivement appliqués sur les entrées e1, e2, e3 du circuit logique 263 du générateur. Plus particulièrement, le signal binaire in1 est un signal logique de commande de l'interrupteur 253, le signal binaire in2 est un signal logique de commande de l'interrupteur 251, et le signal binaire in3 est un signal de commande de l'interrupteur 261.

Le circuit logique 263 a pour rôle de transposer les signaux logiques in1, in2, in3, fournis par le circuit de contrôle 103, en des signaux de commande effectifs des interrupteurs 251, 253, 259 et 261 du générateur d'impulsions TXᵢ.

Plus particulièrement, en phase d'émission ou d'excitation, le circuit de contrôle 103 applique sur le noeud e3 du circuit 263 un signal in3 de commande en ouverture de l'interrupteur 261. Le circuit logique 263 commande alors, via son noeud de sortie s3, l'ouverture de l'interrupteur 261. Les interrupteurs 253 et 251 sont commandés, vias les noeuds s1 et s2, en fonction de l'état des signaux in1 et in2. Plus particulièrement, le circuit 263 transmet directement les signaux d'entrée in1 et in2 sur ses noeuds de sortie s1 et s2. En phase d'émission, le circuit 263 commande en outre l'interrupteur 259 via son noeud de sortie s4, de façon que l'interrupteur 259 soit ouvert lorsqu'au moins un des interrupteurs 251 et 253 est fermé et soit fermé lorsque les interrupteurs 251 et 253 sont tous les deux ouverts.

En phase de réception, le circuit de contrôle 103 applique sur le noeud e3 du circuit 263 un signal in3 de commande en ouverture de l'interrupteur 261. Le circuit logique 263 commande alors, via son noeud de sortie s3, l'ouverture de l'interrupteur 261, et, via son noeud de sortie s4, la fermeture de l'interrupteur 259. Les interrupteurs 259 et 261 restent respectivement fermé et ouvert indépendamment de l'état des signaux d'entrée in1 et in2 appliqués sur les noeuds d'entrée e1 et e2 du circuit 263.

Dans cet exemple, les diodes 255 et 257 forment, en phase de réception, une barrière de potentiel pour les signaux retour générés par les transducteurs, de façon à éviter qu'une partie de la puissance du signal retour ne soit perdue dans le générateur d'impulsions.

A titre d'exemple, la fonction logique f mise en oeuvre par le circuit 263, telle que {s1, s2, s3, s4}=f({e1, e2, e3}), est définie par la table de vérité suivante:

| e1 | e2 | e3 | s1 | s2 | s3 | s4 |
|---|---|---|---|---|---|---|
| x | x | 1 | 0 | 0 | 1 | 1 |
| 0 | 0 | 0 | 0 | 0 | 0 | 1 |
| 0 | 1 | 0 | 0 | 1 | 0 | 0 |
| 1 | 0 | 0 | 1 | 0 | 0 | 0 |
| 1 | 1 | 0 | 0 | 0 | 0 | 1 |

, où les valeurs 1 et 0 désignent respectivement un signal de commande en fermeture et un signal de commande en ouverture, et où la valeur x peut être indifféremment égale à 1 ou à 0.

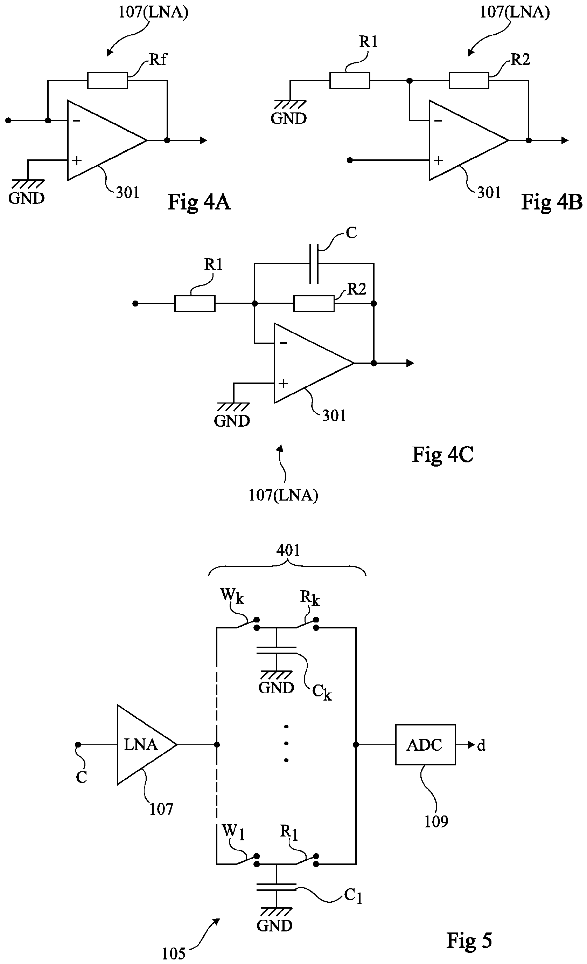

Les figures 4A, 4B et 4C sont des schémas électriques illustrant plus en détail trois variantes de réalisation de l'amplificateur de réception 107 (LNA) du circuit de commande 100 de la figure 1.

La figure 4A illustre un premier exemple de réalisation de l'amplificateur 107. Dans cet exemple, l'amplificateur 107 est un amplificateur de type transimpédance. Il comprend un amplificateur opérationnel 301 dont l'entrée inverseuse (-) est reliée à la sortie par l'intermédiaire d'une résistance Rf. L'entrée inverseuse de l'amplificateur opérationnel 301 est reliée à l'entrée de l'amplificateur 107, et la sortie de l'amplificateur opérationnel 301 est reliée à la sortie de l'amplificateur 107. L'entrée non inverseuse (+) de l'amplificateur opérationnel 301 est reliée au noeud de référence GND du circuit.

La figure 4B illustre un autre exemple de réalisation de l'amplificateur 107. Dans cet exemple, l'amplificateur 107 est un amplificateur de type buffer. Il comprend un amplificateur opérationnel 301 dont l'entrée inverseuse (-) est reliée d'une part au noeud de référence GND par l'intermédiaire d'une résistance R1, et d'autre part à sa sortie par l'intermédiaire d'une résistance R2. L'entrée non inverseuse (+) de l'amplificateur opérationnel 301 est reliée à l'entrée de l'amplificateur 107, et la sortie de l'amplificateur opérationnel 301 est reliée à la sortie de l'amplificateur 107.

La figure 4C illustre un autre exemple de réalisation de l'amplificateur 107. Dans cet exemple, l'amplificateur 107 est un amplificateur de type amplificateur de charge. Il comprend un amplificateur opérationnel 301 dont l'entrée inverseuse (-) est reliée d'une part à l'entrée de l'amplificateur 107 par l'intermédiaire d'une résistance R1, et d'autre part à sa sortie par l'intermédiaire d'une résistance R2 et d'une capacité C connectée en parallèle de la résistance R2. L'entrée non inverseuse (+) de l'amplificateur opérationnel 301 est reliée au noeud de référence GND du circuit. La sortie de l'amplificateur opérationnel 301 est reliée à la sortie de l'amplificateur 107.

Le choix du type d'amplificateur 107 parmi les montages des figures 4A, 4B et 4C peut être réalisé en fonction de l'impédance des transducteurs ultrasonores destinés à être commandés par le circuit 100. En particulier, les montages des figures 4A et 4C sont particulièrement adapté à des transducteurs présentant des impédances élevées, par exemple supérieures à 2 kΩ, tandis que le montage de la figure 4B est adapté à des transducteurs d'impédance plus faible, par exemple de l'ordre de 200 Ω à 2 kΩ. A titre d'exemple, le circuit de réception 105 du circuit de commande 100 peut comporter plusieurs amplificateurs de réception 107 différents, et un circuit de multiplexage configurable pour sélectionner l'amplificateur de réception 107 à utiliser en fonction du type de transducteurs utilisé.

La figure 5 est un schéma électrique illustrant une variante de réalisation du circuit de réception 105 du circuit de commande 100 de la figure 1. Dans l'exemple représenté, par souci de simplification, le circuit d'adaptation d'impédance 111, le circuit d'ajustement de gain 113, et le filtre antirepliement 115 n'ont pas été représentés.

Le circuit de réception 105 de la figure 5 diffère du circuit de réception 105 de la figure 1 principalement en ce qu'il comprend en outre, entre l'amplificateur 107 et le convertisseur analogique numérique 109, un réseau de capacités commutées 401 permettant de mémoriser de façon analogique des échantillons du signal de sortie de l'amplificateur 107, préalablement à leur numérisation par le convertisseur 109. Un avantage de la variante de la figure 5 est qu'elle permet de réduire la fréquence de fonctionnement du convertisseur analogique numérique 109, et donc la puissance électrique consommée par le convertisseur.

Dans l'exemple représenté, le réseau de capacités commutées 401 comprend K condensateurs C₁, ..., C_{K}, avec K entier supérieur à 1, et, pour chaque condensateur Cⱼ, avec j entier allant de 1 à K, un interrupteur d'écriture Wⱼ reliant une première électrode du condensateur à la sortie de l'amplificateur 107, et un interrupteur de lecture Rⱼ reliant la deuxième électrode du condensateur à l'entrée du convertisseur analogique numérique 109. Les interrupteurs Wⱼ et Rⱼ sont par exemple commandés par le circuit de contrôle 103. En fonctionnement, des échantillons du signal analogique de sortie de l'amplificateur 107 sont successivement mémorisés dans les différentes capacités Cⱼ du réseau 401, à la fréquence d'échantillonnage souhaitée du signal électrique de réponse produit par le transducteur connecté au circuit de réception. Ces échantillons analogiques sont ensuite successivement numérisés par le convertisseur analogique numérique 109, à une fréquence inférieure à la fréquence d'échantillonnage du signal analogique. A titre d'exemple, le nombre K de capacités du réseau de capacités 401 est égal au nombre d'échantillons du signal électrique de réponse que l'on souhaite acquérir lors d'une séquence d'émission/réception d'ondes ultrasonores.

Dans le cas où le circuit de réception 105 comprend au moins un des éléments 113 et 115 (figure 1), le réseau de capacités commutées 401 peut être disposé en aval de ces éléments, c'est-à-dire entre ces éléments et le convertisseur analogique numérique 109.

Dans le cas où le circuit de commande 100 comprend plusieurs voies de réception 105, chaque voie de réception peut comporter un réseau de capacités commutées 401 du type décrit en relation avec la figure 5.

Des modes de réalisation particuliers ont été décrits. Diverses variantes et modifications apparaîtront à l'homme de l'art.

Par ailleurs, on notera que les exemples de réalisation décrits ci-dessus peuvent être adaptés quel que soit l'agencement des transducteurs ultrasonores à commander. En particulier, les modes de réalisation décrits sont compatibles avec des agencements en barrette linéaire ou en matrice des transducteurs ultrasonores.

De plus, dans les exemples de réalisation décrits ci-dessus, le circuit de contrôle 100 peut être utilisé pour commander des associations en parallèle de plusieurs transducteurs ultrasonores. Plus particulièrement, dans l'exemple de la figure 1, plusieurs transducteurs ultrasonores reliés en parallèle peuvent être connecté entre chaque borne de commande individuelle a1 et la borne commune b du circuit de contrôle 100.

On notera par ailleurs que la prévision selon l'invention, dans le circuit de réception 105, d'un réseau de capacités commutées 401 disposé en amont du convertisseur analogique-numérique 109, permettant de mémoriser des échantillons analogiques représentatifs du signal de sortie de l'amplificateur de réception 107 préalablement à leur numérisation par le convertisseur analogique-numérique, tel que décrit en relation avec la figure 5, est avantageuse y compris dans un circuit de commande de transducteurs ultrasonores

## Revendications

1. Circuit de commande (100) de transducteurs ultrasonores (TD₁, ..., TDₙ), comportant une première borne (b) destinée à être connectée à une première électrode (E1) de chacun des transducteurs (TD₁, ..., TDₙ), et un commutateur de polarisation (SWp) configurable pour connecter la première borne (b) à l'un ou l'autre de premier (P1) et deuxième (P2) noeuds de polarisation,
le circuit de commande comprenant en outre un circuit de réception (105) comportant un noeud d'entrée (c), un amplificateur de réception (107) dont l'entrée est reliée au noeud d'entrée (c), un convertisseur analogique-numérique (109) dont l'entrée est reliée à la sortie de l'amplificateur de réception (107), et une sortie (d) reliée à la sortie du convertisseur analogique-numérique (109),
le circuit de réception (105) comprenant un réseau (401) de capacités commutées disposé en amont du convertisseur analogique-numérique (109), permettant de mémoriser des échantillons analogiques représentatifs du signal de sortie de l'amplificateur de réception (107), préalablement à leur numérisation par le convertisseur analogique-numérique (109).

2. Circuit de commande (100) selon la revendication 1, comportant un circuit (117) de fourniture d'une tension de polarisation continue (V_{bias}) dont un noeud de sortie est connecté au premier noeud de polarisation (P1), et dans lequel le deuxième noeud de polarisation (P2) est un noeud (GND) d'application d'un potentiel de référence du circuit de commande (100).

3. Circuit de commande (100) selon la revendication 2, dans lequel le circuit (117) de fourniture d'une tension de polarisation continue (V_{bias}) comprend un convertisseur de tension continu-continu configurable pour modifier le niveau de la tension de polarisation (V_{bias}) qu'il délivre.

4. Circuit de commande (100) selon l'une quelconque des revendications 1 à 3, comprenant une pluralité de deuxièmes bornes (a₁, ..., aₙ) destinées à être reliées respectivement à des deuxièmes électrodes (E2) des transducteurs (TD₁, ..., TDₙ) à commander.

5. Circuit de commande (100) selon la revendication 4, comprenant une pluralité de générateurs d'impulsions de tension (TXi, ..., TXₙ), chacune des deuxièmes bornes (a₁, ..., aₙ) étant reliée à l'un des générateurs d'impulsions de tension.

6. Circuit de commande (100) selon la revendication 5, dans lequel le niveau de tension des impulsions de tension délivrées par les générateurs d'impulsions (TX₁, ..., TXₙ) est configurable.

7. Circuit de commande (100) selon l'une quelconque des revendications 1 à 6, comprenant une pluralité d'interrupteurs (SWRX₁, ... SWRXₙ) reliant respectivement les deuxièmes bornes (a₁, ..., aₙ) au noeud d'entrée (c) du circuit de réception.

8. Circuit de commande (100) selon l'une quelconque des revendications 1 à 6, dans lequel le circuit de réception (105) comprend un circuit d'adaptation d'impédance (111) configurable en fonction du type de transducteurs à commander.

9. Circuit de commande (100) selon l'une quelconque des revendications 1 à 8, dans lequel le circuit de réception (105) comprend en outre, entre l'amplificateur de réception (107) et le convertisseur analogique-numérique (109), au moins l'un des éléments suivants :
un circuit analogique d'ajustement de gain (113) ; et
un filtre analogique antirepliement (115).

## Patentansprüche

1. Schaltung (100) zur Steuerung von Ultraschallwandlern (TD₁, ..., TDₙ), die einen ersten Anschluss (b) aufweist, der dazu bestimmt ist, mit einer ersten Elektrode (E1) jedes der Wandler (TD₁, ..., TDₙ) verbunden zu werden, und einen Vorspannungsschalter (SW_{P}) aufweist, der konfiguriert werden kann, den ersten Anschluss (b) mit dem einen oder dem anderen von ersten (P1) und zweiten (P2) Vorspannungsknoten zu verbinden,
wobei die Steuerschaltung weiterhin eine Empfangsschaltung (105) aufweist, die einen Eingangsknoten (c) aufweist, einen Empfangsverstärker (107), dessen Eingang mit dem Eingangsknoten (c) gekoppelt ist, einen Analog-Digital-Wandler (109), dessen Eingang mit dem Ausgang des Empfangsverstärkers (107) gekoppelt ist, und einen Ausgang (d) aufweist, der mit dem Ausgang des Analog-Digital-Wandlers (109) gekoppelt ist,
wobei die Empfangsschaltung (105) ein Array (401) geschalteter Kondensatoren aufweist, die stromaufwärts des Analog-Digital-Wandlers (109) angeordnet sind und es ermöglichen, analoge Abtastwerte zu speichern, die das Ausgangssignal des Empfangsverstärkers (107) darstellen, bevor sie durch den Analog-Digital-Wandler (109) digitalisiert werden.

2. Steuerschaltung (100) nach Anspruch 1, die eine Schaltung (117) aufweist, die dazu bestimmt ist, eine Vorspannungsgleichspannung (V_{bias}) zu liefern, deren Ausgangsknoten mit dem ersten Vorspannungsknoten (P1) verbunden ist, und wobei der zweite Vorspannungsknoten (P2) ein Knoten (GND) zum Anlegen eines Bezugspotentials der Steuerschaltung (100) ist.

3. Steuerschaltung (100) nach Anspruch 2, wobei die Gleichstromschaltung (117), die eine Vorspannungsgleichspannung (V_{bias}) liefern soll, einen Gleichspannungswandler aufweist, der konfiguriert werden kann, den Pegel der Vorspannung (V_{bias}), die er liefert, zu modifizieren.

4. Steuerschaltung (100) nach einem der Ansprüche 1 bis 3, die eine Vielzahl von zweiten Anschlüssen (a₁, ..., aₙ) aufweist, die dazu bestimmt sind, jeweils mit zweiten Elektroden (E2) der zu steuernden Wandler (TD₁, ..., TDₙ) gekoppelt zu werden.

5. Steuerschaltung (100) nach Anspruch 4, die eine Vielzahl von Spannungsimpulsgeneratoren (TXi, ..., TXₙ) aufweist, wobei jeder der zweiten Anschlüsse (a1, ..., an) mit einem der Spannungsimpulsgeneratoren gekoppelt ist.

6. Steuerschaltung (100) nach Anspruch 5, wobei der Spannungspegel der von den Impulsgeneratoren (TX₁, ..., TXₙ) gelieferten Spannungsimpulse konfigurierbar ist.

7. Steuerschaltung (100) nach einem der Ansprüche 1 bis 6, die mehrere Schalter (SWRX₁, ... SWRXₙ) aufweist, die jeweils die zweiten Anschlüsse (a₁, ..., aₙ) mit dem Eingangsknoten (c) der Empfangsschaltung verbinden.

8. Die Steuerschaltung (100) nach einem der Ansprüche 1 bis 6, wobei die Empfangsschaltung (105) eine Impedanzanpassungsschaltung (111) aufweist, die je nach Art der zu steuernden Wandler konfigurierbar ist.

9. Steuerschaltung (100) nach einem der Ansprüche 1 bis 8, wobei die Empfangsschaltung (105) ferner zwischen dem Empfangsverstärker (107) und dem Analog-Digital-Wandler (109) mindestens eines der folgenden Elemente aufweist:
eine analoge Verstärkungseinstellschaltung (113); und
ein analoges Anti-Aliasing-Filter (115).

## Claims

1. A circuit (100) of control of ultrasound transducers (TD₁, ..., TDₙ), comprising a first terminal (b) intended to be connected to a first electrode (E1) of each of the transducers (TD₁, ..., TDₙ), and a bias switch (SWp) configurable to connect the first terminal (b) to one or the other of first (P1) and second (P2) bias nodes,
the circuit of control further comprising a receive circuit (105) comprising an input node (c), a receive amplifier (107) having its input coupled to the input node (c), an analog-to-digital converter (109) having its input coupled to the output of the receive amplifier (107), and an output (d) coupled to the output of the analog-to-digital converter (109),
wherein the receive circuit (105) comprises an array (401) of switched capacitors arranged upstream of the analog-to-digital converter (109), enabling to store analog samples representative of the output signal of receive amplifier (107) prior to their digitization by the analog-to-digital converter (109).

2. The control circuit (100) of claim 1, comprising a circuit (117) intended to supply a DC bias voltage (V_{bias}) having an output node connected to the first bias node (P1), and wherein the second bias node (P2) is a node (GND) of application of a reference potential of the control circuit (100).

3. The control circuit (100) of claim 2, wherein the DC circuit (117) intended to supply a DC bias voltage (V_{bias}) comprises a DC/DC voltage converter configurable to modify the level of the bias voltage (V_{bias}) that it delivers.

4. The control circuit (100) of any of claims 1 to 3, comprising a plurality of second terminals (a₁, ..., aₙ) intended to be respectively coupled to second electrodes (E2) of the transducers (TD₁, ..., TDₙ) to be controlled.

5. The control circuit (100) of claim 4, comprising a plurality of voltage pulse generators (TXᵢ, ..., TXₙ), each of the second terminals (a₁, ..., aₙ) being coupled to one of the voltage pulse generators.

6. The control circuit (100) of claim 5, wherein the voltage level of the voltage pulses delivered by the pulse generators (TX₁, ..., TXₙ) is configurable.

7. The control circuit (100) of any of claims 1 to 6, comprising a plurality of switches (SWRX₁, ... SWRXₙ) respectively coupling the second terminals (a₁, ..., aₙ) to the input node (c) of the receive circuit.

8. The control circuit (100) of any of claims 1 to 6, wherein the receive circuit (105) comprises an impedance matching circuit (111) configurable according to the type of transducers to be controlled.

9. The control circuit (100) of any of claims 1 to 8, wherein the receive circuit (105) further comprises, between the receive amplifier (107) and the analog-to-digital converter (109), at least one of the following elements:
an analog gain adjustment circuit (113); and
an analog anti-aliasing filter (115).
